(19) **Europäisches Patentamt** **European Patent Office** **Office européen des brevets**

(11) **EP 4 105 693 B1**

(12) **EUROPEAN PATENT SPECIFICATION**

(45) Date of publication and mention of the grant of the patent:
**02.07.2025 Bulletin 2025/27**

(21) Application number: **21179967.1**

(22) Date of filing: **17.06.2021**

(51) International Patent Classification (IPC):
*G02B 5/00* (2006.01)   *G02B 5/18* (2006.01)
*H02S 10/30* (2014.01)   *H10N 99/00* (2023.01)

(52) Cooperative Patent Classification (CPC):
**G02B 5/1809; G02B 5/008; H10N 99/00**

(54) **SPECTRALLY-SELECTIVE AND DIRECTIONAL THERMAL ELECTROMAGNETIC RADIATION EMITTER**

SPEKTRALSELEKTIVER UND DIREKTIONALER STRAHLER VON THERMISCHER ELEKTROMAGNETISCHER STRAHLUNG

ÉMETTEUR DE RAYONNEMENT ÉLECTROMAGNÉTIQUE THERMIQUE SPECTRALEMENT SÉLECTIF ET DIRECTIONNEL

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**21.12.2022 Bulletin 2022/51**

(73) Proprietor: **Valstybinis Moksliniu Tyrimu Institutas Fiziniu Ir Technologijos Mokslu Centras 02300 Vilnius (LT)**

(72) Inventors:
• **JANONIS, Vytautas**
  **10257 Vilnius (LT)**
• **KASALYNAS, Irmantas**
  **10257 Vilnius (LT)**

(74) Representative: **Draugeliene, Virgina Adolfina Tarpine Ltd**
**A. P. Kavoliuko g. 24-152**
**04328 Vilnius (LT)**

(56) References cited:
**US-A1- 2015 228 844**

• **JANONIS VYTAUTAS ET AL: "Spatial coherence of hybrid surface plasmon-phonon-polaritons in shallow n-GaN surface-relief gratings", OPTICS EXPRESS, vol. 29, no. 9, 21 April 2021 (2021-04-21), pages 13839, XP055863190, DOI: 10.1364/OE.423397**
• **XUEJI WANG ET AL: "High Temperature Thermal Photonics", ARXIV.ORG, CORNELL UNIVERSITY LIBRARY, 201 OLIN LIBRARY CORNELL UNIVERSITY ITHACA, NY 14853, 4 August 2020 (2020-08-04), XP081733322, DOI: 10.1615/ ANNUALREVHEATTRANSFER.2020032805**

**Description**

Field of the invention

The present invention relates to apparatus for emitting in normal direction a quasi-monochromatic, coherent radiation enhanced by the excitation of hybrid polaritons.

Background of the invention

USA patent No. US8987754B1, published on March 24, 2015, describes the directional thermal emitter of electromagnetic radiation based on two-dimensional (2D) array of heavily doped semiconductor structures formed on the solid substrate surface with a thin layer of noble metal added to fill the array troughs. Proposed device generates highly directional radiation at specified wavelengths via thermal excitation of surface plasmon polaritons (SPPs), which are polarization waves of free electron plasma propagating at metal-dielectric interface, on a metal surface side, where the radiation of selected mode is highly directional in the angle defined by dispersion law of the SPP. Silicon and indium arsenide semiconductors are used for fabrication of rectangular shape 2D structures, required for generation of SPP quasiparticles. Drawback of proposed method is a design complexity, proposed shape of 2D structures, which fabrication requires precise procedures, a stacking of various materials, such as IV group semiconductors for SPP excitation and noble metals to maximize light reflectivity, and last but not least, the excited SPPs radiate in different angles according to the dispersion law. The fabrication, exploitation and even reliability of the device face many problems due to these specific requirements. Moreover, the spatial coherence of SPP quasiparticles is small because the damping factor of electron or hole plasma oscillations is large. Even more, it degrades with semiconductor doping and especially under heavily doping regime when it is required doping values as large as $10^{20}$cm$^{-3}$. The application of proposed method is narrow, the integration in one system a few of various wavelength emitters, where each radiate beam in a different angle, is complicated. USA patent application No. US2018/0045861A1 published on February 15, 2018, describes the thermal IR emission device based on the surface phonon-polaritons (SPhPs) excited in the array of nano-scale polar semiconductor material structures arranged on the substrate. In this case, the damping factor of SPhP oscillations is considerably smaller in comparison to their counterparts SPPs. Therefore, the quality factor (linewidth) of SPhPs device emission is much higher (narrower) with acceptable emission power levels even at moderate temperatures. However, method propose the usage of complex designs employing multi-layer material stacks of the ferroelectrics, heater materials, which utilize complex electrical current drive through the heater and its heat dissipation, and materials changing phase from a "metallic" to a "dielectric" state, where each has individual requirements on functionality and specific physical properties such as high heat conductivity, transparency in the IR region, etc. All these make the fabrication and exploitation of the IR emission device very complex, limit its practical application. Moreover, the operation frequency range of the device is narrow, limited by oscillation frequencies of the TO and LO phonons of undoped polar semiconductor with additional requirement for IR transparency, and the excited SPhPs radiate in different angles according to the dispersion law.

USA patent application No. US2015228844A1 published on August 13, 2015, which describes the spectrally-selective metamaterial emitter based on the SPPs excitation in the array of concentric rings designed to convert heat energy into a highly directional beam. The emitter is integrally formed on the surface of a solid substrate, forming concentric circular ridges and intervening concentric circular grooves which separate the ridges by the same period. When the metamaterial emitter is heated to the operating temperature (e.g., 1000 K), surface plasmons radiation of thermal energy is highly directional (i.e., 90% of the emitted radiant energy is within 0.5° of perpendicular to the planar outward-facing surface), narrow band (i.e., the full-width at half maximum of the emitted radiant energy is within 10% of the peak emission wavelength), and a its peak emission wavelength is roughly equal to the grating period (i.e., the peak emission wavelength is within 25% of the grating period).

The method proposes to form a "multiplexed" pattern of overlapping concentric rings, where multiplexing of spectrally-selective metamaterial emitters is performed in order to increase spectral bandwidth and maximize radiant energy concentration to the photo-voltaic (PV) cell. Emitter and method for emitting radiant energy have limited applications because the concentration and mixing of adjacent narrowband spectra are done with the aim to maximize emitter performance in a wide spectrum range.

Used metals for the excitation of SPPs possess large damping factors which result in a small value of the spatial coherence of the polaritons. Proposed device is developed for photo-voltaic applications where the thermal energy of broadband excess heat is converted into electricity by passing the in-band photons to an associated target photo-voltaic cell. However, such device is not suitable in the spectroscopy, imaging, secure communication, big-data transfer, and similar applications.

Even more, all-metal construction of the metamaterial emitter is designed to operate at high temperatures, from 1000 to 1500° K, and that limits practical applications of the device. Moreover, the usage of refractory metals (e.g.,

Rhenium, Tantalum or Tungsten) and their alloys, used usually in high-performance jets and rocket engines, rises emitter cost which limits number of applications.

Closest analogue is JANONIS VYTAUTAS ET AL: "Spatial coherence of hybrid surface Plasmon-phonon-polaritons in shallow n-GaN surface-relief gratings", OPTICS EXPRESS, vol.29, no.9. 21 April 2021, page 13839-13851, investigating the radiation properties of hybrid surface plasmon phonon polaritons (SPPhPs) excited in heavily doped n-type gallium nitride (GaN) gratings discovered to radiate transverse magnetic (TM) polarized electromagnetic waves in the angle defined by the dispersion law of SPPhPs. It was discovered that doped GaN semiconductor characterized by oscillation frequencies of transverse TO and longitudinal LO optical phonons and free charge carrier plasma with respective oscillation damping factors can be used for the excitation of hybrid SPPhP modes in the surface relief grating made of a linear shape and of a period, filling factor, and depth of 11 $\mu$m, 50 %, and 1 $\mu$m respectively (JANONIS VYTAUTAS ET AL: "Investigation of n-type gallium nitride grating for applications in coherent thermal sources", APPLIED PHYSICS LETTERS, vol. 116, issue 11, 18 March 2020, page 112103 (https://doi.org/10.1063/1.5143220). A year later, a comprehensive investigation of different period but the same 50 % filling factor gratings revealed the dispersion characteristics of hybrid SPPhPs, radiation of which was found in a narrowband spectrum range demonstrating experimental values of the angular broadening and the linewidth to be as small as 0.66 deg and 6.4 cm$^{-1}$, respectively. The narrowest linewidth of the emission peak was found always near the TO phonon frequency demonstrating similar quality factor values independently from change in grating period. Meanwhile, the coherence length was found to be dependent on the period as the propagation losses of hybrid SPPhP modes showed a tendency to accumulate with the decrease of period values.

The known spectrally selective and directional thermal emitter of electromagnetic radiation comprises a solid substrate made of a polar semiconductor material, which is characterized by a transverse TO and longitudinal LO optical phonons, described by respective oscillation frequencies $v_{TO}$ and $v_{LO}$, wavelengths $\lambda_{TO}$ and $\lambda_{LO}$, and damping factors $\Gamma_{TO}$ and $\Gamma_{LO}$, which volume is doped with free charge carriers of one type, electrons or holes, with an oscillation frequency of free carrier plasma, $v_P$, which is higher than oscillation frequency of a longitudinal optical phonons $v_{LO}$, and on a surface of which integrally is formed a surface grating of ridges (2) of a width W and grooves (3) periodically arranged with a period P at a depth h, wherein h is in a range of $\lambda_{TO}/40$ to $\lambda_{TO}/16$, so that the surface hybrid plasmon-phonon polaritons to radiate transverse magnetic (TM) polarized electromagnetic waves at the frequencies $v_{osc}$ which with the wavevector are connected by a relationship $k_{osc} = 2\pi v_{osc}$..

The use of the known emitter is limited, because in this emitter is uncontrolled excitation of different modes, their radiate in different angles not the one, and possess large propagation losses resulting in poor spectral quality and increased angular broadening of SPPhP radiation. Moreover, not optimal shape and periodic grove parameters as well as arrangement of the surface-relief gratings result in deterioration of beam quality and power therefore limit applications of known method.

Technical problem to be solved

This invention aims to increase number of practical applications of spectrally selective thermal emitters, simplifying and simultaneously reducing the fabrication cost, increasing reliability, and achieving sustainable usage of wasted thermal energy.

Disclosure of the invention

This is achieved by the proposed spectrally selective and directional thermal emitter of electromagnetic radiation according to claims 1-8.

Advantages of the invention

The proposed emitter generates in normal direction a quasi-monochromatic, coherent beam enhanced by the excitation of hybrid polaritons employing integral solid-state solutions. Such emitter is useful for thermo-photoelectric, bio-sensor, chemical-sensor, etc. applications where compact solution for narrowband (quasi-monochromatic) and directive (coherent) emission driven by heat and electrical current sources is needed in the spectrum range from 5 THz till 34 THz.

The emitter may also radiate at other frequencies, however, its radiation is weak at all non-optimized frequencies. Therefore proposed spectrally selective thermal emitter radiates only in normal direction, which is convenient in number of applications such as, information exchange, powering of devices from wasted thermal radiation, recycling and utilization of thermal energy, information consolidation and allocation, data transfer, contactless irradiation and concentration of thermal energy, spectroscopic imaging and spectroscopy.

The hybrid polaritonic (HP) emitter is proposed to fabricate of polar semiconductor material in a form surface grating, where different sign but the same frequency hybrid polariton modes are used to generate the beam in normal direction with a small angular broadening and narrow spectral linewidth, the operation frequency is selected from the range of $v_{TO}$-2$\Gamma_{TO}$ to $v_{LO}$+20%, where the deviation of 20% from $v_{LO}$ frequency is for a case of n-GaN grating with $v_P/v_{LO} \geq 1.5$.

Since according to the claimed invention, the grating filling factor is ranging from 30 % to 10% value, the propagation losses of the hybrid polaritons in polar semiconductor material grating are considerably smaller in comparison to those found for gratings with the filling factor of 50 %.

Brief description of the drawings

Fig.1 is a schematic cross-section of a one-dimensional periodic grating, fabricated of the polar semiconductor material, used for the excitation of hybrid surface plasmon phonon polaritons - hybrid polaritons (HPs).

Fig.2 shows HP emitter radiation frequency, $v_{osc}$, and amplitude, *Am,* which is calculated as the difference between emitter emissivity in TM and TE polarizations, dependences on the grating period at the radiation angle $\varphi$=0 deg.

Fig.3 shows HP emitter radiation angle and frequency characteristic of the fundamental harmonics at the grating filling factor *FF*=0.25 and the period $P_1$=17.8 $\mu$m.

Fig.4 shows HP emitter radiation angular characteristics of the fundamental harmonic at the frequency $f_{osc}$=16.8 THz, at the grating filling factor *FF*=0.25.

Fig.5 shows a dependences of the HP emitter fundamental harmonic amplitude, *Am,* (solid line) and radiation angle, $\varphi$, (dashed line) on the grating period at the selected frequency $f_{osc}$=16.8 THz, at the grating filling factor *FF*=0.25.

Fig.6 shows a dependence of the radiation frequency of selected modes of the HP emitter, emitting in normal direction, on the grating period for different values of the filling factor.

Fig.7 shows a dependence of the radiation amplitude, *Am,* of selected modes of the HP emitter, emitting in normal direction, on the operation frequency, $v_{osc}$, for different values of the grating filling factor.

Fig.8 shows a dependence of the radiation quality factor, *Q,* of selected modes of the HP emitter, emitting in normal direction, on the operation frequency, $v_{osc}$, for different values of the grating filling factor.

Fig.9 shows a dependences of the HP emitter fundamental harmonic frequency, $v_{osc}$, and amplitude, *Am,* (intensity of black color) on the grating filling factor at the selected period $P_1$=17.6 $\mu$m.

Fig.10 shows a field plot of electromagnetic field TM component of the fundamental harmonic at the frequency $v_{osc}$ = 568 cm$^{-1}$, radiated of the HP emitter with the grating period $P_1$ = 17.6 $\mu$m and the filling factor *FF* = 0.25.

Fig.11 shows a field plot of electromagnetic field TM component of the second harmonic at the frequency $v_{osc}$ = 568 cm$^{-1}$, radiated of the HP emitter with the grating period $P_2$ = 35.2 $\mu$m and filling factor *FF* = 0.25.

Fig.12 is a cross section view of the HP emitter with radial symmetry.

Fig.13 shows bottom, top, and side views of the HP emitter with radial symmetry. Radiated beam is registered with a small area detector.

Fig.14 shows bottom, top, and side views of the radially symmetric HP emitter and the aperture, used for spatial filtering, both with radial symmetry. Radiated beam is registered with a large area detector.

Fig.15 is an assembly scheme of the HP emitter with radial symmetry in a metal holder similar to a male type of the coaxial cable connector.

Fig.16 is an arrangement of the multiple HP emitters in plane in a geometry of triangle unit cell.

Description of embodiment of the invention

The invention describes the selectable frequency source emitting thermal energy coherently in one, perpendicular direction as the result of the excitation and constructive interaction of the hybrid surface plasmon-phonon polaritons (hybrid polaritons - HPs) in the surface grating. Proposed HP device can be fabricated of a heavily doped polar semiconductor, such as GaN, AlN, SIC, InSb, GaAs, etc., material in which the interaction of photons (light) with material phonons and plasmons produces the quasiparticles - hybrid-polaritons, which oscillations damping factor is significantly reduced due to hybridization phenomenon of polaritons, described in our previous research. [JANONIS VYTAUTAS ET AL: "Spatial coherence of hybrid surface plasmon-phonon-polaritons in shallow n-GaN surface-relief gratings", OPTICS EXPRESS, vol.29, no.9. 21 April 2021, page 13839].

Parameters of phonons and electrons for several commercially available polar semiconductors are summarized in Table 1. Volume doping of selected polar semiconductor material is needed to be of such size that the oscillation frequency of free charge plasma, $\nu_P$, should be higher than the LO phonon frequency, $\nu_{LO}$, in that material. For example, volume doping of the GaN material, possessing the transfer TO phonons with frequency of 559 cm$^{-1}$ and the longitudinal LO phonons with frequency of 734 cm$^{-1}$, is required with donor impurities to the level of electron density of 6.37E+18 cm$^{-3}$ and 1.50E+19 cm$^{-3}$ in order to fulfill condition $\nu_P = \nu_{LO}$ and $\nu_P \approx 1.5\,\nu_{LO}$, respectively. This principle can be applied to all polar semiconductors, which are listed in Table 1 and others, which are considered to use in the development of the HP device for a specific spectrum range (see column "Range 2" in Table 1), without deterioration of the linewidth and the spatial coherence length values, which are determined by material TO and LO phonon oscillation frequencies, $\nu_{TO}$ and $\nu_{LO}$, and damping factors, $\Gamma_{TO}$ and $\Gamma_{LO}$, and oscillation parameters of the free charge plasma, $\nu_P$ and $\Gamma_P$, respectively.

Table 1. Parameters of different polar semiconductor materials. Material parameters $\nu_{TO}$, $\Gamma_{TO}$, $\nu_{LO}$, $\Gamma_{LO}$ were taken from J.D. CALDWELL ET AL: " Low-loss, infrared and terahertz nanophotonics using surface phonon polaritons", NANOPHOTONICS vol. 4, issue 1, 13April 2015, pages 44-68], JANONIS VYTAUTAS ET AL: "Investigation of n-type gallium nitride grating for applications in coherent thermal sources", APPLIED PHYSICS LETTERS, vol. 116, issue 11, 18 March 2020, page 112103], while $\varepsilon_\infty$, $m^*$, $\Gamma_P$ were taken from the database [http://www.ioffe.ru/ SVA/NSM/ Semicond].

| Material | $\varepsilon_\infty$ | $\nu_{TO}$, ($\Gamma_{TO}$) cm$^{-1}$ | $\nu_{LO}$, ($\Gamma_{LO}$), cm$^{-1}$ | $m^*$ | N($\nu_P$ =$\nu_{LO}$), cm$^{-3}$ | $\Gamma_P$, cm$^{-1}$ | Range 1 from $\nu_{TO}$-$\Gamma_{TO}$ till 1.2$\nu_{TO}$, cm$^{-1}$ (THz) | Range 2 from $\nu_{TO}$-2$\Gamma_{TO}$ till 1.2$\nu_{LO}$, cm$^{-1}$ (THz) |
|---|---|---|---|---|---|---|---|---|
| 3C-SiC | 6.5 | 784 (2) | 951 (3.4) | 0.68 | 4.46E+19 | 15 | 782-878 (23.4-26.3) | 778-1141 (23.3-34.2) |
| w-AlN | 4.8 | 600 (3) | 911 (6) | 0.4 | 1.78E+19 | 78 | 597-672 (17.91-20.15) | 594-1093 (17.8-32.8) |
| n-GaN | 5.3 | 557 (7) | 739 (7) | 0.2 | 6.37E+18 | 390 | 550-624 (16.5-18.7) | 543-887 (16.3-26.6) |
| InP | 9.61 | 317 (1) | 340 (0.01) | 0.08 | 9.92E+17 | 23 | 316-355 (9.47-10.64) | 315-408 (9.44-12.23) |
| GaAs | 10.89 | 274 (2) | 294 (2) | 0.063 | 6.62E+17 | 49 | 272.5-307 (8.17-9.20) | 271-353 (8.12-10.68) |
| InAs | 12.3 | 227 (4) | 244 (0.1) | 0.023 | 1.88E+17 | 20 | 223-254 (6.69-7.62) | 219-293 (6.58-8.78) |
| InSb | 15.7 | 183 (2) | 202 (1.8) | 0.014 | 1.00E17 | 13 | 181-204 (5.42-6.14) | 179-242 (5.37-7.27) |

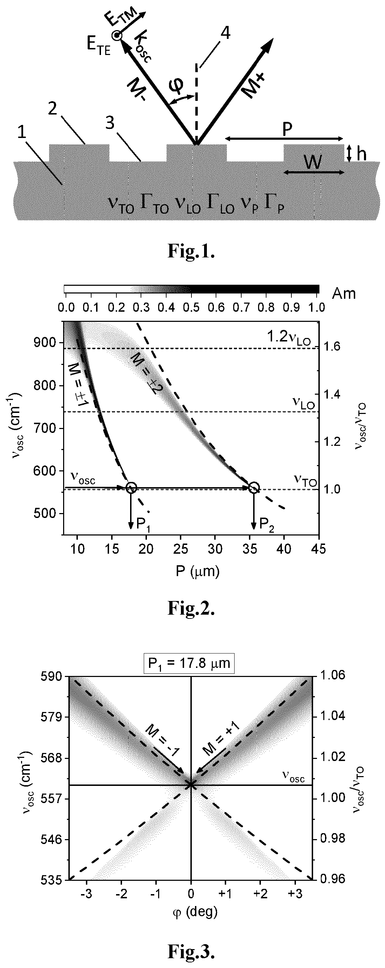

Cross section view of one-dimensional periodic grating, used for the excitation of surface polaritons, is shown in Fig. 1. Hybrid polaritons will be generated in the surface grating, when the grating 1 is fabricated of the polar semiconductor material which volume is doped with free charge carriers of one type, electrons or holes, up to the level of such size that the oscillation frequency of charge plasma, $\nu_P$, is higher than the oscillation frequency of longitudinal optical phonons, $\nu_{LO}$, i.e. $\nu_P/\nu_{LO} > 1$. Geometrical parameters of the grating: the period, the width of ridge 2 and the depth of groove 3 are labeled as $P$, $W$, and $h$ respectively. Excited hybrid polaritons radiate electromagnetic waves at the specific frequency $\nu_{osc}$ with the wavevector $k_{osc}$, in the direction, angle of which $\varphi$ is measured from normal vector 4 to the surface. In case of one-dimensional grating, the polaritons radiate light of transverse magnetic (TM) polarization, $E_{TM}$, which electric field component is oriented perpendicular to the grating grooves. Background thermal radiation is also observed in transverse electric (TE) polarization, $E_{TE}$, with light electric field component oriented parallel to the substrate surface and the grating grooves. Periodic shallow groove structures of selected period and filling factor, $FF = W/P$, are integrally fabricated on the surface of polar semiconductor by using an UV photolithography procedures followed by reactive ion etching with aim for a small surface roughness and small number of fabrication defects as it has been demonstrated in our previous research. [JANONIS VYTAUTAS ET AL: "Spatial coherence of hybrid surface plasmon-phonon-polaritons in shallow n-GaN surface-relief gratings", OPTICS EXPRESS, vol.29, no.9. 21 April 2021, page 13839]. Optimal groove depth for polaritons excitation in n-GaN grating is approximately of 1 μm, corresponding to $\lambda_{TO}/17$, where $\lambda_{TO}$ is the wavelength of TO phonons. For other polar semiconductors, the optimal groove depth can be further adjusted modeling numerically a hybrid polariton dispersion by RCWA (Rigorous Coupled Wave Analysis) method. It is known that in case of undoped SiC semiconductor, the optimal groove depth for the excitation of surface polaritons is $\lambda/40$, which is about twice less than used in case of a heavily doped polar semiconductors for the excitation of the hybrid polaritons.

Polaritons are waves propagating at air/material or material/material interface and possessing an electromagnetic filed amplitude decay in the normal direction to the interface with maximum field value at the interface. Such surface waves (evanescent waves) interact with periodic profile of the grating and radiate to a free space at the angle $\varphi$ and at the frequency $\nu_{osc}$, values of which are found by solving the dispersion equation for hybrid polaritons:

$$\nu_{osc}^2 \, \frac{\epsilon_s \epsilon_0}{\epsilon_s + \epsilon_0} - \left( \nu_{osc} \sin \varphi + M/P \right)^2 = 0 \qquad (1)$$

wherein $\varepsilon_0$ and $\varepsilon_s$ are the complex dielectric functions of materials possessing positive (air) and negative (polar semiconductor in the Reststrahlen band) values of real part of complex numbers, respectively, $M$ is the mode number which is an integer ($M = 1, 2, ...$). In case of isotropic approximation, the complex dielectric function of polar semiconductor is defined by the phonon and plasmon parameters:

$$\epsilon_s = \epsilon_\infty \left( \frac{\nu_{LO}^2 - \nu_0^2 - i\nu\Gamma_{LO}}{\nu_{TO}^2 - \nu_0^2 - i\nu\Gamma_{TO}} - \frac{\nu_P^2}{\nu_0^2 + i\nu\Gamma_P} \right), \qquad (2)$$

wherein $\varepsilon_\infty$ is the high frequency dielectric constant of polar semiconductor material. The first term of this equation describes the contribution of phonon oscillations and the second the contribution of free charge plasma oscillations to the dielectric function of material, where the plasmon oscillation frequency, $\nu_p$, is proportional to the density, $N$, and the

$$2\pi c \nu_p = \sqrt{e^2 N / m^* \epsilon_\infty}$$

effective mass, $m^*$, of free charge carriers as ⟨above equation⟩, where c is the speed of light in vacuum c = 3 $\times 10^{10}$ (cm/s). It is worth to note that when $\varphi = 0$, the equation (1) is valid for two modes with the same frequency but opposite sign, i.e. $M = -1$ or $M = +1$, $M = -2$ or $M = +2$, etc. Therefore, two polariton modes with positive and negative sign of the same frequency can be generated in the grating fabricated of polar semiconductor material, here a positive sign indicates polariton propagation towards direction of the light Poynting vector, while a negative sign - its backward propagation.

Equations (1)-(2) are generalized and can be applied describing hybrid polaritons in different polar semiconductor materials, characterized by phonon and plasmon oscillation frequencies and damping factors, which numerical values depend on the selected material nature, production and processing technology. The performance of the HP emitter is found by the use of sample made of n-GaN crystal, which phonon and plasmon parameters are obtained experimentally and are summarized in Table 1. All characteristics of the HP emitter are measured numerically by using the RCWA method, which provides a good quantitative description of the experimental results of shallow n-GaN gratings with different period as it has been demonstrated in our previous research.

Fig. 2 shows the dependence of the HP emitter frequency, $\nu_{osc}$, and the amplitude, $Am$, calculated as the difference between the TM and TE polarization emissivities, on the grating period at the emission angle $\varphi = 0$ deg. The numerical solution of Equation (1), in a case of a flat polar semiconductor surface, i.e. without taking into account the propagation losses of hybrid polaritons in the grating, is shown by the corresponding dotted lines for the first, $M\pm 1$, and second, $M\pm 2$, order modes. The result differs from that obtained by the RCWA method, especially in the higher frequency region, where the dotted lines deviate significantly from the zone center where the emissivity is highest (black-gray color). It worse to note that such emitter is suitable to generate the frequencies from $\nu_{TO}$ to 20 %, i.e. $\nu_{TO} \leq \nu_{osc} \leq 1.2\,\nu_{LO}$ or $\nu_{TO} \leq \nu_{osc} \leq 1.6\,\nu_{TO}$. It should be noted also that the maximum frequency range in which the HP emitter operates can be adjusted by varying the density of free charge carriers in the volume of polar semiconductor material as discussed above. For gratings made of various polar semiconductor materials, the operating frequency range from $\nu_{TO} - 2\Gamma_{TO}$ to $1.2\,\nu_{LO}$ is given in column "Range 2" of Table 1.

Fig. 3 shows the frequency and radiation angle characteristic of the fundamental harmonics of the HP emitter using the grating with fixed filling factor and period to values of $FF$=0.25 and $P_1$=17.8 $\mu$m, respectively. The numerical solutions of Equation (1) for each $M$=+1 and $M$=-1 modes are shown by dotted lines. It is seen that in one, normal direction, when $\varphi$=0 deg, the frequencies of both modes coincide and are equal to $\nu_{osc}$=561 cm$^{-1}$, $f_{osc}$=16.8 THz (intersection point of the lines).

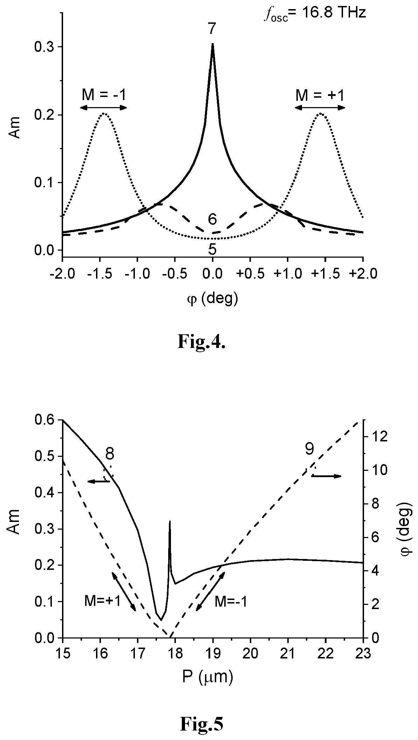

Fig. 4 shows the angular characteristics 5, 6, and 7 of the fundamental harmonics at the selected frequency $f_{osc}$=16.8 THz of the HP emitter radiation, which were found for the filling factor $FF$ = 0.25 gratings of the period $P_1$ of 17.25, 17.50, and 17.86 $\mu$m, respectively. It demonstrates that the hybrid polaritons emit polarized light in the normal direction, $\varphi$=0 degrees, in a narrow range of angles (7, solid line), i.e. the angular broaderning of the beam, $\Delta\varphi$, is found to be less than 0.5 degrees.

Fig. 5 reveals the dependence of $M\pm1$ modes amplitude, $Am$ characteristic 8, and the emission direction, angle $\varphi$ characteristic 9, on the grating period, $P$. It is seen that by changing the lattice period from 15 $\mu$m iki 17.86 $\mu$m, the modes $M\pm1$ emission angle changes from $\pm12$ to 0 deg, the amplitude decreases, and in a vicinity of the angle $\varphi$=0 deg, the amplitude suddenly increases due to a constructive interaction between two modes. It is worth to note that at the limit of $\varphi$=0 deg and $P$=17.86 $\mu$m, the shape of angular emission characteristic 7 of the HP emitter (see Fig. 4) becomes symmetric with the angular broadening at full width half maximum and the coherence length values being down to $\Delta\varphi$=0.32 deg and up to $L_{sc}$=179 $\lambda_{osc}$, respectively. When the periodicity is further increased in the range of $P$ values between 17.86 $\mu$m and 23, the modes $M\pm1$ split, their emission anlge deviates from the normal direction, angular characteristics become more asymmetric, and their amplitudes decrease. Thus, the condition of the same frequency and direction for both $M\pm1$ (or higher order) modes is fulfilled only at the emission angle of $\varphi$=0 deg, under this condition the total emission amplitude of the HP emitter is enhanced by the constructive interaction between two modes possessing the same frequency but an opposite sign.

The propagation losses of the hybrid polaritons, $\Gamma_{PL}$, are smallest near the frequency of the TO phonons, $\nu_{osc}\approx\nu_{TO}$, and, in case of symmetric n-GaN gratings, their value is $\Gamma_{PL}$=2.8 cm$^{-1}$, as it has been found in our previous research. [JANONIS VYTAUTAS ET AL: "Spatial coherence of hybrid surface plasmon-phonon-polaritons in shallow n-GaN surface-relief gratings", OPTICS EXPRESS, vol.29, no.9. 21 April 2021, page 13839]. These propagation losses of hybrid polaritons must be evaluated and taken into account in the development and application of the HP emitter. Here we propose to reduce propagation and radiation losses of hybrid polaritons by the optimization of grating filling factor value and/or by the usage of higher order polariton harmonics.

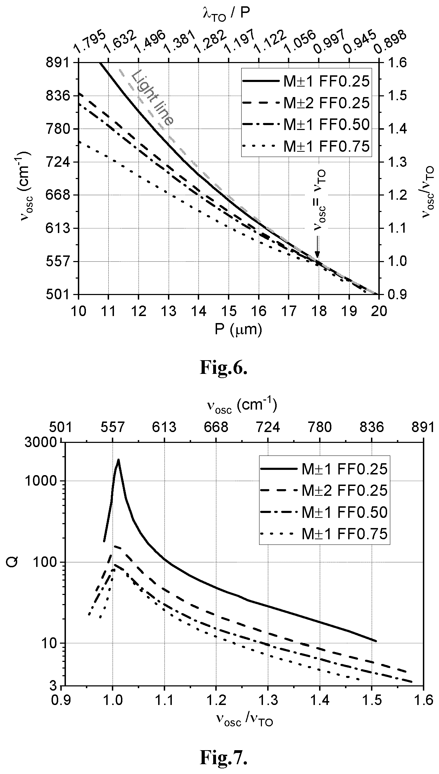

Fig. 6 shows the dependence of the oscillation frequency of the HP emitter radiating in normal direction, $\nu_{osc}$, on the grating period, $P$, at various filling factor values at the fundamental and second order harmonics. The dependence of the numerical solution of equation (1) on the grating period is shown by a gray dashed line labeled as "Light line".

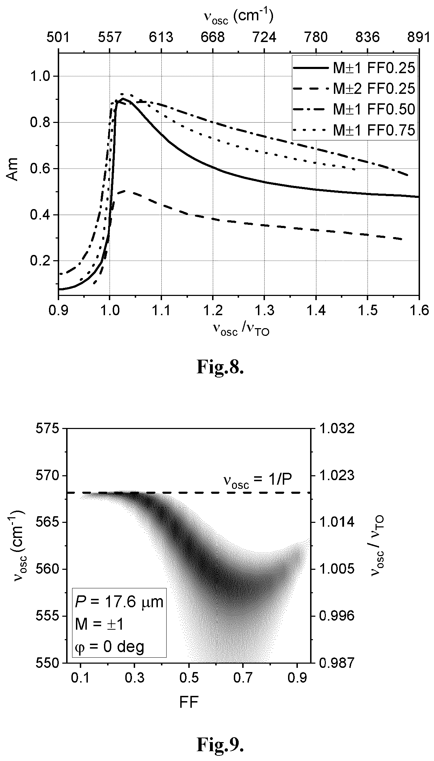

The results in Fig. 7 reveal how the spectral quality, Q, (the linewidth normalized to the operation frequency, $\Delta\nu_{osc}/\nu_{osc}$) of the emitter radiation depends on the variation of the grating period in the range from 10 to 20 $\mu$m for same grating filling factors and mode numbers, which are listed in Fig.6., while data in Fig. 8 reveal respective dependences for the amplitude, $Am$, of the HP emitter radiation.

The results demosntrate that at $FF$=0.25, the spectral quality of the first and second modes of hybrid polyarithon radiation in all frequency range under consideration is higher than that found for the gratings with filling factor of 50%, which are not covered by the subject-matter of the claims, described in our previous research. There is a practical interest in the frequency range from $\nu_{TO}-\Gamma_{TO}$ to $\nu_{TO}$+12%, where the propagation losses of hybrid polaritons in the grating are small and where polaritons emit a high spectral quality beam with Q values up to 100 or even higher due to the constructive interaction between the same frequency, opposite sign modes radiating in normal direction. This frequency range for different materials is indicated in column "Range 1" of Table 1.

It should be noticed that the spectral quality of the radiated beam can be also improved by choosing a higher mode number. For example, in case of $M\pm2$, the spectral quality of radiated beam is also high due to smaller polariton propagation losses in the grating with $FF$=0.25 (see Fig. 7) Obtained quality facetor values are higher than that found in case of fundamental modes in the grating with $FF$=0.50, which emission amplitude remains higher up to 2 times (see Fig. 8). The examples with $FF$=0.50 or $FF$=0.75 are not covered by the subject-matter of the claims.

The dependence of the fundamental harmonic of the HP emitter operation frequency on the filling factor is shown in Fig.9. These results reveal that, when the grating filling factor, $FF$, is in the range of 0.4 to 0.9, which is not covered by the subject-matter of the claims, selecting the mode number and the period, one has to take into account also the frequency $\nu_{osc}$ dependence on the period $P$, which is shown in Fig. 6. When the filling factor is 0.50, which is not covered by the subject-matter of the claims, the spectral linewidth is limited to value of $\Delta\nu \approx 6$ cm$^{-1}$ due to significant propagation losses of hybrid polaritons, found in our previous research. In this case, the parameters of the radiated beam of the HP emitter, based on n-GaN grating with $\nu_P \approx 1.5\nu_{LO}$, for various operation frequencies, raging from $\nu_{TO}-2\Gamma_{TO}$ to $\nu_{TO}$+33%, are summarized in Table 2.

Table. 2. Calculated coherence length, $L_{sc}$, and spectral quality factor, $Q$, of the n-GaN emitter sample employing modes $M=\pm 1$ at $FF$=0.50, which is not covered by the subject-matter of the claims.

| $\nu_{osc}$, (cm$^{-1}$) | $f_{osc}$, (THz) | $\nu_{osc}/\nu_{TO}$ | $P$ (μm) | $\Delta\varphi$ (deg) | $L_{sc}$, (mm) | $L_{sc}/\lambda_{osc}$ | $_{\Delta}V$ (cm$^{-1}$) | $Q$ |
|---|---|---|---|---|---|---|---|---|
| 545 | 16.3 | 0.978 | 18.3 | 0.86 | 1.21 | 66 | 11.5 | 47 |
| 559 | 16.7 | 1.004 | 17.8 | 0.52 | 1.69 | 111 | 6 | 93 |
| 580 | 17.4 | 1.041 | 16 | 0.97 | 1.02 | 59 | 10.5 | 55 |
| 600 | 18.0 | 1.077 | 16.2 | 1.97 | 0.48 | 29 | 15 | 40 |
| 739 | 22.1 | 1.327 | 12.4 | 8.90 | 0.09 | 6.4 | 87 | 8.5 |

However, the propagation losses of hybrid polariton modes in the grating are significantly reduced by selecting the filling factor of the range 0.30 to 0.10 as required by the claimed invention. In this case, Fig. 9 and Fig. 6 reveal that the HP emitter radiation frequency $\nu_{osc}$ is inversely proportional to the period $P$ or emitted wavelength $\lambda_{osc}$ is approximately equal to P. Such the emitter will radiate narrow spectral line, high spectral quality beam with large coherence length and small angular broadening if its operation frequency, $\nu_{osc}$, is from the range of $\nu_{osc} \approx \nu_{TO}\pm\Gamma_{TO}$, where the excited hybrid polariton oscillations in polar semiconductor possess very small values of the damping factor.

In case of $FF$=0.25, the highest spectral quality ($Q$ = 1818), the narrowest spectral linewidth ($\Delta\nu$=0.31 cm$^{-1}$), the highest coherence ($L_{sc}$ = 1484 $\lambda_{osc}$) with the smallest angular broadening ($\Delta\varphi$ = 0.039 deg) of the radiated beam of the emitter first harmonic is found at the frequency $\nu_{osc}$=564 cm$^{-1}$. Meanwhile, when the second harmonic of the HP emitter is selected for operation, maximum values of the respective parameters of radiated beam are found to be of $Q$ = 160, $\Delta\nu$=3.5 cm$^{-1}$, $L_{sc}$= 153 $\lambda_{osc}$, and $\Delta\varphi$ = 0.38 deg at the $\nu_{osc}$=560 cm$^{-1}$. The parameters of the radiated beam of the HP emitter, based on n-GaN grating with $\nu_P \approx 1.5\nu_{LO}$, for various oscillation frequencies ranging from $\nu_{TO}$-2$\Gamma_{TO}$ to $\nu_{TO}$+33% of the first and second harmonics are summarized in Table 3 and Table 4, respectively.

In case of larger filling factor value, $FF$=0.75, which is not covered by the subject-matter of the claims, maximum values of the respective parameters of the radiated beam of the emitter first harmonic are found to be only of $Q$=89, $\Delta\nu$=6.3 cm$^{-1}$, $L_{sc}$ = 56 $\lambda_{osc}$ ir $\Delta\varphi$ = 1.02 deg, at the $\nu_{osc}$=560 cm$^{-1}$, due to high propagation losses of hybrid polaritons in the grating. The results of the HP emitter for other frequencies, raging from $\nu_{TO}$-2$\Gamma_{TO}$ to $\nu_{TO}$+33%, are summarized in Table 5.

Table. 3. Coherence length and spectral quality factor of the n-GaN emitter sample employing modes $M=\pm 1$ at $FF$=0.25.

| $\nu_{osc}$, (cm$^{-1}$) | $f_{osc}$, (THz) | $\nu_{osc}/\nu_{TO}$ | $P$ (μm) | $_{\Delta}\varphi$ (deg) | $Lsc$, (mm) | $L_{sc}/\lambda_{osc}$ | $_{\Delta}V$ (cm$^{-1}$) | $Q$ |
|---|---|---|---|---|---|---|---|---|
| 545 | 16.3 | 0.978 | 18.4 | 0.62 | 1.70 | 92 | 3.7 | 147 |
| 564 | 16.9 | 1.012 | 17.8 | 0.039 | 26.35 | 1484 | 0.31 | 1818 |
| 580 | 17.4 | 1.041 | 17.2 | 0.17 | 5.73 | 332 | 1.9 | 305 |
| 600 | 18.0 | 1.077 | 16.6 | 0.48 | 2.02 | 120 | 4 | 150 |
| 739 | 22.1 | 1.327 | 13.3 | 4.7 | 0.17 | 12 | 29 | 25 |

Table. 4. Coherence length and spectral quality factor of the n-GaN emitter sample employing modes $M=\pm 2$ at $FF$=0.25.

| $\nu_{osc}$, (cm$^{-1}$) | $f_{osc}$, (THz) | $\nu_{osc}/\nu_{TO}$ | $P$ (μm) | $_{\Delta}\varphi$ (deg) | $Lsc$, (mm) | $L_{sc}/\lambda_{osc}$ | $_{\Delta}V$ (cm$^{-1}$) | $Q$ |
|---|---|---|---|---|---|---|---|---|
| 545 | 16.3 | 0.978 | 36.6 | 0.70 | 1.50 | 82 | 8.5 | 64 |
| 560 | 16.8 | 1.005 | 35.6 | 0.38 | 2.70 | 153 | 3.5 | 160 |
| 580 | 17.4 | 1.041 | 34.0 | 0.74 | 1.33 | 77 | 6.0 | 96 |
| 600 | 18.0 | 1.077 | 32.6 | 1.18 | 0.81 | 48 | 10.5 | 57 |
| 739 | 22.1 | 1.327 | 25.0 | 6.2 | 0.12 | 9 | 63.0 | 12 |

Table. 5. Coherence length and spectral quality factor of the n-GaN emitter sample employing modes $M=\pm1$ at $FF$=0.75, which is not covered by the subject-matter of the claims.

| $\nu_{osc}$, (cm$^{-1}$) | $f_{osc}$, (THz) | $\nu_{osc}/\nu_{TO}$ | $P$ ($\mu$m) | $\Delta\varphi$ (deg) | $Lsc$, (mm) | $L_{sc}/\lambda_{osc}$ | $\Delta V$ (cm$^{-1}$) | $Q$ |
|---|---|---|---|---|---|---|---|---|
| 545 | 16.3 | 0.978 | 18.3 | 0.819 | 1.28 | 70 | 23 | 23 |
| 560 | 16.8 | 1.005 | 17.6 | 1.02 | 1.00 | 56 | 6.3 | 89 |
| 580 | 17.4 | 1.041 | 16.9 | 1.77 | 0.56 | 33 | 11 | 52 |
| 600 | 18.0 | 1.077 | 16.2 | 2.52 | 0.38 | 23 | 18 | 33 |
| 739 | 22.1 | 1.327 | 12.0 | 9.85 | 0.08 | 5.8 | 119 | 6.2 |

It should be noted that the results in Figs.6-9 are also plotted on normalized scales, where the HP emitter frequency is normalized to the TO phonon frequency, $\nu_{TO}$, and the grating period is normalized to the wavelength, $\lambda_{TO}$. Since equations (1)-(2) are generalized and apply to any polar semiconductor, described by the corresponding phonon and free charge plasma parameters, the n-GaN results in Figs.6-9 can be directly used in the production of HP emitter for different frequencies. This is demonstrated in Table 1, where other polar semiconductor, such as SiC, AlN, InP, GaAs, InAs, InSb, or the like materials are selected for grating production, without altering the quality and directivity characteristics of the radiated beam of hybrid polaritons.

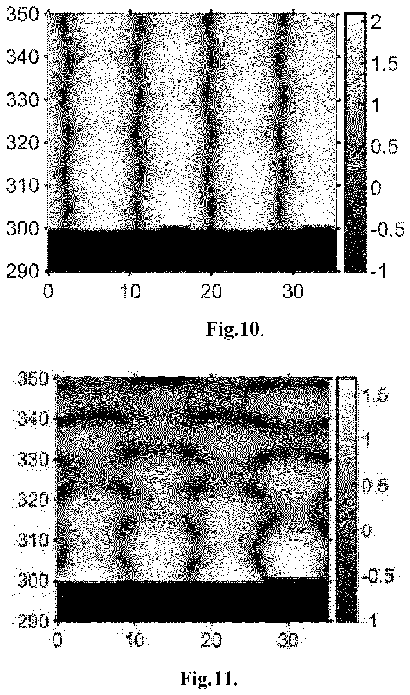

Fig. 10 shows the electromagnetic field plot of the first harmonic TM component of the HP emitter with the grating period $P_1$=17.6 $\mu$m and filling factor $FF$=0.25 operating at the frequency $\nu_{osc}$ = 568 cm$^{-1}$. It is seen that in case of maximum coherence, the field profile is no longer evanescent, indeed a constructive interaction of surface waves of the same frequency is observed found, resulting in lower HP propagation losses and intense radiation in normal direction.

Fig. 11 shows the electromagnetic field plot of the second harmonic TM component of the HP emitter with the grating period $P_2$=35.2 $\mu$m and filling factor $FF$=0.25 operating at the frequency $\nu_{osc}$ = 568 cm$^{-1}$.

Thus, the results in both Fig. 10 and Fig. 11 reveal that the radiation profiles are symmetric with respect to the center of the ridge 10 and the groove 11 of the grating without a difference first or second or higher order modes are excited. Therefore, we propose to define and use the axis of symmetry in the HP emitter design.

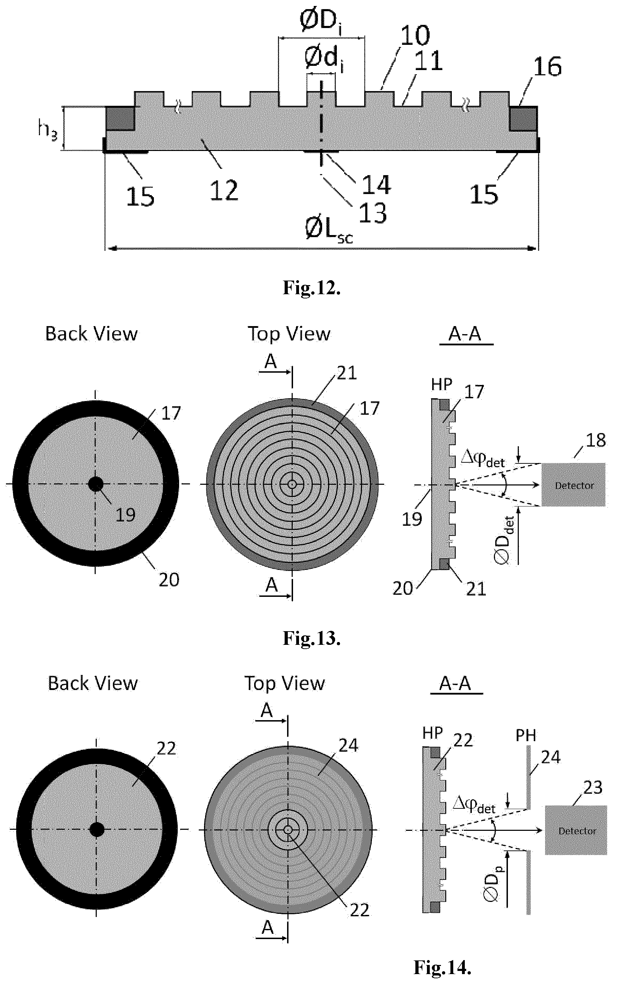

The design of the HP emitter grating with radial symmetry 12 with respect to the axis 13, which extends through the center of the ridge 10, is shown in Fig. 12. Radial symmetry is obtained rotating an one-dimensional grating by 180 degrees around the axis of symmetry 13, which optionally can be placed either in the center of a ridge 10 or center of a groove 11, forming an array of concentric rings as seen in Fig. 12 and Fig. 13.

Such HP emitter with radial symmetry is used to radiate only one selected frequency modes of all polarizations in normal direction, along the axis of symmetry 13, with small angular broaderning of radiated beam due to the constructive interaction of HPs on the surface grating.

The power supply of the HP emitter is implemented by using material own thermal and electrical conductivities, which values are high due to the sufficient free charge density in a volume of dopped polar semiconductor. In the proposed emitter, the hot 14 and cold 15 electrodes are pressed, welded, glued, or otherwise connected to the back side of the HP emitter substrate at the center 14 and the edge of the outer diameter 15 of grating zones, respectively. The powering may be realized by heating from the hot plate, that raises the temperature of the HP emitter to that which is suitable for explotation of the polar semiconductor material, and/or by basing electric current, the amplitude of which can be further modulated in the frequency range of 0-100 MHz, with the maximum value being limited by the heat capacity of the device and by the resistance of thermal contact. The thickness of the polar semiconductor material, $h_3$, also influences the modulation rate, and it should be at least 3.2 $\mu$m in a case of n-GaN to ensure an optical transparency not larger than 1% for all frequencies ranging from 350 cm$^{-1}$ to 1200 cm$^{-1}$.

An outer diameter of the HP emitter with radial symmetry should be the same as the coherence length of the hybrid polaritons, $L_{SC}$. In addition, Breg mirrors 16 can be integrated at a maximum distance equal to $L_{SC}$ value measuring from the center 13 across the entire perimeter of HP emitter, in order to increase the selection of HP modes, in analogy to one used in laser or resonator systems based on standard mirror approach. If the outer diameter of the radial HP emitter is smaller than the size of $L_{SC}$, then the usage of the Breg mirrors 16 allows the reduction of material amount and surface area required for the fabrication of a single emitter without detoriation of spectral quality and angular broaderning of the radiated beam.

Bragg mirror for polaritons is composed of a relief structure of different periodicity, depth, and filing factor processed on the same surface of the semiconductor material as the grating, and/or made of metal that is used for connection of electric current and/or heat electrodes to the HP emitter powering zones 14 and 15.

Fig. 13 shows the HP emitter 17 whose radiation is detected by a small diameter sensor 18. Back side view of the emitter substrate shows zones where "hot" 19 and "cold" 20 electrodes can be connected, while the Bragg mirror 21 over an entire perimeter of the emitter is seen in a top view. In this case, the sensor works as a spatial element whose diameter $D$

defines the field of view angle, $\Delta\varphi_{det}$, for collection of the HP emitter radiation, described by the coherence length, $L_{SC}$, and beam broadening angle, $\Delta\varphi$. Optimum condiction is when both spatial angles are equal, i.e. $\Delta\varphi_{det} = \Delta\varphi$. If the field of view angle is too large, then the detector will measure background radiation not related to coherent radiation of the HP emitter, resulting in a reduction of the signal to noise ratio. Such a design, when it is necessary to select the diameter of the sensor and/or the distance to the HP emitter in order to fulfill the condition $\Delta\varphi_{det} = \Delta\varphi$, may not always be convenient.

Fig. 14 shows the HP emitter 22 whose radiation is detected by a sensor 23 of any shape with dimensions larger than a real experimental field of view angle, $\Delta\varphi_{det}$. For this, it is proposed to use a non-radiating pinhole, PH, 24 as a spatial filter defining the field of view angle, $\Delta\varphi_{det}$, which is used to transmit the coherent beam and block background radiation unrelated to the emitter coherent radiation. In this case, the best beam quality of the HP emitter is achieved when the outer diameter of the emitter is equal to the coherence length $L_{SC}$ and the aperture PH defines the field of view angle, $\Delta\varphi_{det}$, to be equal to the beam broadening angle, $\Delta\varphi$.

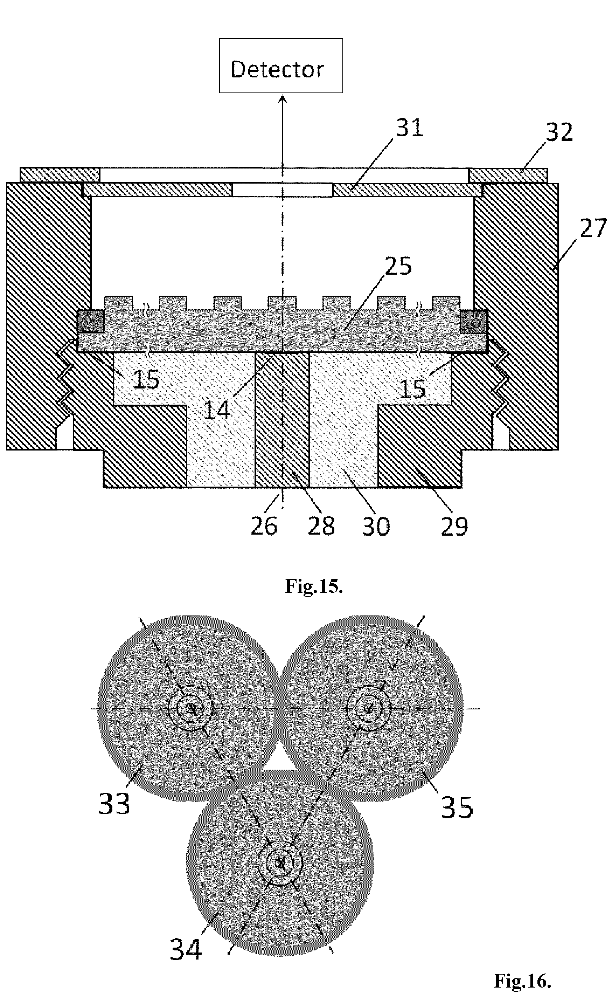

Fig. 15 shows the design of the HP emitter with radial symmetry 25 assembled in a radial shape metal holder 27,28,29 with an axis 26, in which the emitter is fixed by mean of an annular clamp 29. Power is provided using good electrical and thermal conductivities of the polar semiconductor substrate, provided by free-charge carriers. The HP device is powered either by electrical current or thermal heating from the element with hot 28 and cold 29 electrodes, separated by an insulator 30 and clamped to the polar semiconductor substrate in the central 14 and outer zones 15 by an annular clamp 29. In this way, the metal clamp 29 is used to fix the HP emitter grating in the holder and as a cold electrode for power supply. Spatial filtering of the coherent beam is done by a non-radiating pinhole PH 31 which is additionally fixed in the holder by means of a ring-shaped clamp 32 above the grating.

It is worth to note that the increase of the HP emitter temperature increases the power of coherent beam proportionally to the change of temperature. The fabricated HP emitter of n-GaN can operate at +1000 °C or even higher temperatures limited by the melting temperature of the material (+2500 ° C) and/or a possible increase of the damping factor of phonon oscillations, which has not been observed under laboratory conditions up to 500 °C. Unique physical and chemical properties of the GaN make the HP emitters, fabricated of this semiconductor, suitable for the applications in various chemical activity liquids, gases, or environments with high radioactivity, in a wide range of temperatures, 0-2500 °C.

Fig. 16 shows the arrangement of few HP emitters 33, 34, 35, each with radial symmetry 22, 25 and a non-radiating pinhole filter 24, 31, in the corners of an equilateral triangle in order to form a primitive cell. Larger area is filled translating such cell in a plane of the required size and shape, the power radiated in normal direction from each HP emitter pixel is measured by single large-area detector. Such the design of multi-pixel HP emitters allows the increase of total emission power in proportion to the number of pixels. Densest filling of multi-pixel HP emitters is achieved in an equilateral triangular design, resulting in maximum coherent radiation power which is possible to obtain from an unit area.

Each individual pixel 33, 34, 35 of the HP emitter, possessing radial symmetry, can be designed in a way to emit beams of the same or different frequencies in the normal direction, which are measured by individual detectors. Such HP emitters are suitable for the selective spectroscopic imaging in wide spectrum range, also for two-dimensional spectroscopy, for selective spectrum control and/or use of an excess thermal energy, for information transfer over parallel channels operating on the same or different frequencies, and other applications.

**Claims**

1. Spectrally selective and directional thermal emitter of electromagnetic radiation comprising a solid substrate made of a polar semiconductor material (1), which is **characterized by** transverse TO and longitudinal LO optical phonons, described by respective oscillation frequencies $\nu_{TO}$ and $\nu_{LO}$, wavelengths $\lambda_{TO}$ and $\lambda_{LO}$, and damping factors $\Gamma_{TO}$ and $\Gamma_{LO}$, which volume is doped with free charge carriers of one type, electrons or holes so, that a volume doping of the material is such, that an oscillation frequency of free carrier plasma, $\nu_P$, is higher than the oscillation frequency of longitudinal optical phonons $\nu_{LO}$, and on a surface of which integrally is formed a surface grating of ridges (2) of a width W and grooves (3) periodically arranged with a period P at a depth h, wherein h is in a range of $\lambda_{TO}/40$ to $\lambda_{TO}/16$, wherein excited hybrid surface plasmon-phonon polaritons radiate transverse magnetic (TM) polarized electromagnetic waves at the frequencies $\nu_{osc}$, which with the wavevector are connected by a relationship $k_{osc} = 2\pi\nu_{osc}$, in an angle $\varphi$, defined as the inclination angle between the direction of wavevector $k_{osc}$ and a normal direction (4) of the surface grating, wherein the surface grating formed integrally with solid substrate (1) is configured so, that to fulfill parameter set as follows:

   - an operation frequency $\nu_{osc}$ of hybrid surface plasmon-phonon polaritons is in a frequency range from $\nu_{TO}-2\Gamma_{TO}$ to $1.2\nu_{LO}$ depending on a polariton mode number M, the period P and a filling factor FF, wherein FF=W/P, of the surface grating,
   - a radiation of said operation frequency $\nu_{osc}$ is in the normal direction (4) when the angle $\varphi=0$ ,

- the hybrid surface plasmon-phonon polaritons, being of a opposite sign but the same $M=\pm1$, $M=\pm2$, or higher mode number, interact in the surface grating constructively,

**characterised in that** the filling factor *FF* is in the range from 30 % to 10 %.

2. Emitter according to claim 1, **characterized in that** the polar semiconductor material used for the embodiment of the emitter is selected from a group of GaN, SiC, AIN, InP, GaAs, InAs and InSb.

3. Emitter according of any one of claims 1-2, **characterized in that** the surface grating is configured of a radial symmetry to radiate a directional beam at the operation frequency $v_{osc}$ in the normal direction, $\varphi=0$, along the symmetry axis (13) due to a constructive interaction of the hybrid surface plasmon-phonon polaritons of all polarisations in the surface grating with radial symmetry.

4. Emitter according to claim 3, **characterized in that** the surface grating *of the* radial symmetry has a shape of concentric rings with the symmetry axis (13) placed in the center of one of ridges (2) or in the center of one of grooves (3).

5. Emitter according of any one of claims 3-4, **characterized in that** an outer diameter $(\varnothing L_{SC})$ of the surface grating of the radial symmetry is equal to a spatial coherence length $L_{SC}$ of the hybrid plasmon-phonon polaritons of the operation frequency, $v_{osc}$, or smaller.

6. Emitter according to any one of claims 3-5, **characterized in that** the emitter comprises Bragg mirrors (16, 21) which are configured to reflect the hybrid surface plasmon-phonon polaritons of the operation frequency $v_{osc}$ and which are arranged around the surface grating with radial symmetry at a radius ($\varnothing L_{SC}/2$), equal to the spatial coherence length $L_{SC}$ of the hybrid surface plasmon-phonon polaritons or smaller.

7. Emitter according to any one of claims 1-6, **characterized in that** the emitter comprises a thermal source (28, 29) for heating the solid substrate (1) of the emitter

8. Emitter according to any one of claims 1-6, **characterized in that** the emitter comprises an electrical source for powering the emitter and applying electric energy to the solid substrate (1) through electrical contacts (15, 14) on the back side of solid substrate to the center and around all perimeter of the emitter, causing flow of an electric current through a back side of the emitter and modulating amplitude of bias current in the frequency range of 0-100 MHz.

**Patentansprüche**

1. Spektralselektiver und direktionaler Strahler von thermischer elektromagnetischer Strahlung, umfassend ein festes Substrat aus einem polaren Halbleitermaterial (1), die durch transversale TO- und longitudinale LO-optische Phononen gekennzeichnet ist, die beschrieben sind durch jeweilige Schwingungsfrequenzen $v_{TO}$ und $v_{LO}$, Wellen-längen $\lambda_{TO}$ und $\lambda_{LO}$ und Dämpfungsfaktoren $\Gamma_{TO}$ und $\Gamma_{LO}$, deren Volumen mit freien Ladungsträgern einer Art, Elektronen oder Löchern, dotiert ist, so dass eine Volumendotierung des Materials derart ist, dass eine Schwingungs-frequenz des freien Trägerplasmas, $v_P$, höher ist als die Schwingungsfrequenz von longitudinalen optischen Phononen $v_{LO}$, und auf einer Oberfläche davon integral ein Oberflächengitter aus Stegen (2) einer Breite W und Nuten (3) gebildet ist, die periodisch mit einer Periode P in einer Tiefe h angeordnet sind, wobei h in einem Bereich von $\lambda_{TO}/40$ bis $\lambda_{TO}/16$ liegt, wobei angeregte hybride Oberflächenplasmon-Phonon-Polaritonen transversalmagnetische (TM) polarisierte elektromagnetische Wellen bei den Frequenzen $v_{osc}$ abstrahlen, die mit dem Wellenvektor durch eine Beziehung $k_{osc}= 2\pi v_{osc}$ in einem Winkel $\varphi$ verbunden sind, der als der Neigungswinkel zwischen der Richtung des Wellenvektors $k_{osc}$ und einer Normalrichtung (4) des Oberflächengitters definiert ist, wobei

das integral mit dem festen Substrat (1) gebildete Oberflächengitter so konfiguriert ist, dass der folgende Parametersatz erfüllt ist:

- eine Betriebsfrequenz $v_{osc}$ der hybriden Oberflächenplasmon-Phonon-Polaritonen in einem Frequenzbe-reich von $v_{TO}$-$2\Gamma_{TO}$ bis $1,2v_{LO}$ in Abhängigkeit von einer Polaritonmodenzahl *M, der* Periode P und einem Füllfaktor *FF*, wobei *FF=W/P,* des Oberflächengitters liegt,
- eine Strahlung der Betriebsfrequenz $v_{osc}$ in der Normalrichtung (4) liegt, wenn der Winkel $\varphi=0$,

- die hybriden Oberflächenplasmon-Phonon-Polaritonen, die ein entgegengesetztes Vorzeichen, aber die gleiche $M=\pm1$, $M=\pm2$ oder eine höhere Modenzahl aufweisen, im Oberflächengitter konstruktiv interagieren,

**dadurch gekennzeichnet, dass** der Füllfaktor FF in einem Bereich von 30 % bis 10 % liegt.

2. Strahler nach Anspruch 1, **dadurch gekennzeichnet, dass** das für die Ausführungsform des Strahlers verwendete polare Halbleitermaterial ausgewählt ist aus einer Gruppe von GaN, SiC, AIN, InP, GaAs, InAs und InSb.

3. Strahler nach einem der Ansprüche 1-2, **dadurch gekennzeichnet, dass** das Oberflächengitter mit einer radialen Symmetrie konfiguriert ist, um einen direktionalen Strahl bei der Betriebsfrequenz $v_{osc}$ in der Normalrichtung, $\varphi=0$ , entlang der Symmetrieachse (13) aufgrund einer konstruktiven Interaktion der hybriden Oberflächenplasmon-Phonon-Polaritonen aller Polarisationen in dem Oberflächengitter mit radialer Symmetrie abzustrahlen.

4. Strahler nach Anspruch 3, **dadurch gekennzeichnet, dass** das Oberflächengitter der radialen Symmetrie eine Form konzentrischer Ringe aufweist, wobei die Symmetrieachse (13) in der Mitte eines der Stege (2) oder in der Mitte einer der Nuten (3) platziert ist.

5. Strahler nach einem der Ansprüche 3-4, **dadurch gekennzeichnet, dass** ein Außendurchmesser ($\varnothing L_{SC}$) des Oberflächengitters mit der radialen Symmetrie gleich einer räumlichen Kohärenzlänge $L_{SC}$ der hybriden Plasmon-Phonon-Polaritonen der Betriebsfrequenz $v_{osc}$ oder kleiner ist.

6. Strahler nach einem der Ansprüche 3-5, **dadurch gekennzeichnet, dass** der Strahler Bragg-Spiegel (16, 21) umfasst, die dazu konfiguriert sind, die hybriden Oberflächenplasmon-Phonon-Polaritonen der Betriebsfrequenz $v_{osc}$ zu reflektieren, und die um das Oberflächengitter mit radialer Symmetrie bei einem Radius ($\varnothing L_{SC}/2$) angeordnet sind, der gleich der räumlichen Kohärenzlänge $L_{SC}$ der hybriden Oberflächenplasmon-Phonon-Polaritonen oder kleiner ist.

7. Strahler nach einem der Ansprüche 1-6, **dadurch gekennzeichnet, dass** der Strahler eine thermische Quelle (28, 29) zum Erwärmen des festen Substrats (1) des Strahlers umfasst.

8. Strahler nach einem der Ansprüche 1-6, **dadurch gekennzeichnet, dass** der Strahler eine elektrische Quelle zum Speisen des Strahlers und Anlegen von elektrischer Energie an das feste Substrat (1) durch elektrische Kontakte (15, 14) auf der Rückseite des festen Substrats zur Mitte und um den gesamten Perimeter des Strahlers umfasst, wodurch bewirkt wird, dass ein elektrischer Strom durch eine Rückseite des Strahlers fließt und die Amplitude des Vorspannungsstroms im Frequenzbereich von 0-100 MHz moduliert wird.

## Revendications

1. Émetteur thermique spectralement sélectif et directionnel de rayonnement électromagnétique comprenant un substrat solide en matériau semi-conducteur polaire (1), **caractérisé par** des phonons optiques transversaux TO et longitudinaux LO, décrits par des fréquences d'oscillation respectives $v_{TO}$ et $v_{LO}$, des longueurs d'onde $\lambda_{TO}$ et $\lambda_{LO}$, et des facteurs d'amortissement $\Gamma_{TO}$ et $\Gamma_{LO}$, dont le volume est dopé avec des porteurs de charge libres d'un type, des électrons ou des trous de sorte qu'un dopage volumique du matériau soit tel qu'une fréquence d'oscillation du plasma porteur libre, $v_P$, soit supérieure à la fréquence d'oscillation des phonons optiques longitudinaux $v_{LO}$, et sur une surface duquel est formé intégralement un réseau de surface de crêtes (2) d'une largeur W et de rainures (3) disposées périodiquement avec une période P à une profondeur $h$, dans lequel $h$ est dans une plage de $\lambda_{TO}/40$ à $\lambda_{TO}/16$, dans lequel les plasmon-phonon polaritons de surface hybrides excités rayonnent des ondes électromagnétiques polarisées transverses magnétiques (TM) aux fréquences $v_{osc}$, qui sont reliées au vecteur d'onde par une relation $k_{osc}=2\pi v_{osc}$, dans un angle $\varphi$, défini comme l'angle d'inclinaison entre la direction du vecteur d'onde $k_{osc}$ et une direction normale (4) du réseau de surface,
dans lequel

le réseau de surface formé intégralement avec le substrat solide (1) est configuré de sorte de respecter le jeu de paramètres suivant :

- une fréquence de fonctionnement $v_{osc}$ de plasmon-phonon polaritons de surface hybrides se situe dans une gamme de fréquences allant de $\nu_{TO}$-2$\Gamma_{TO}$ à 1,21$\nu_{LO}$ en fonction d'un nombre de mode polariton *M, de la* période *P* et d'un facteur de remplissage *FF,* dans lequel *FF=W/P,* du réseau de surface,
- un rayonnement de ladite fréquence de fonctionnement $\nu_{osc}$ est dans la direction normale (4) lorsque l'angle φ=0 ,
- les plasmon-phonon polaritons de surface hybrides, étant de signe opposé mais le même *M=±1, M=±2,* ou un nombre de mode supérieur, interagissent de manière constructive dans le réseau de surface,

**caractérisé en ce que** le facteur de remplissage FF se situe dans la plage de 30 % à 10 %

2. Emetteur selon la revendication 1, **caractérisé en ce que** le matériau semi-conducteur polaire utilisé pour la réalisation de l'émetteur est sélectionné dans un groupe de GaN, SiC, AIN, InP, GaAs, InAs et InSb.

3. Émetteur selon l'une quelconque des revendications 1 à 2, **caractérisé en ce que** le réseau de surface est configuré selon une symétrie radiale pour rayonner un faisceau directionnel à la fréquence de fonctionnement $\nu_{osc}$ dans la direction normale, φ=0 , le long de l'axe de symétrie (13) en raison d'une interaction constructive des plasmon-phonon polaritons de surface hybrides de toutes les polarisations dans le réseau de surface avec une symétrie radiale.

4. Emetteur selon la revendication 3, **caractérisé en ce que** le réseau de surface de la symétrie radiale a une forme d'anneaux concentriques avec l'axe de symétrie (13) placé au centre de l'une des arêtes (2) ou au centre de l'une des rainures (3).

5. Émetteur selon l'une quelconque des revendications 3 à 4, **caractérisé en ce qu'**un diamètre extérieur *($\varnothing L_{SC}$/2)* du réseau de surface de la symétrie radiale est égal à une longueur de cohérence spatiale $L_{SC}$ des plasmon-phonon polaritons hybrides de la fréquence de fonctionnement, $\nu_{osc}$, ou inférieure.

6. Émetteur selon l'une quelconque des revendications 3 à 5, **caractérisé en ce que** l'émetteur comprend des miroirs de Bragg (16, 21) qui sont configurés pour réfléchir les plasmon-phonon polaritons de surface hybrides de la fréquence de fonctionnement $\nu_{osc}$ et qui sont agencés autour du réseau de surface avec une symétrie radiale à un rayon ($\varnothing L_{SC}$/2), égal à la longueur de cohérence spatiale $L_{SC}$ des plasmon-phonon polaritons de surface hybrides ou inférieur.

7. Émetteur selon l'une quelconque des revendications 1 à 6, **caractérisé en ce que** l'émetteur comprend une source thermique (28, 29) pour chauffer le substrat solide (1) de l'émetteur.

8. Émetteur selon l'une quelconque des revendications 1 à 6, ***caractérisé* en ce que** l'émetteur comprend une source électrique pour alimenter l'émetteur et appliquer de l'énergie électrique au substrat solide (1) par l'intermédiaire de contacts électriques (15, 14) sur la face arrière du substrat solide au centre et autour de tout le périmètre de l'émetteur, provoquant la circulation d'un courant électrique à travers une face arrière de l'émetteur et modulant l'amplitude du courant de polarisation dans la gamme de fréquences de 0 à 100 MHz

**Fig.1.**

**Fig.2.**

**Fig.3.**

**Fig.4.**

**Fig.5**

**Fig.6.**

**Fig.7.**

Fig.8.

Fig.9.

Fig.10.

Fig.11.

**Fig.12.**

**Fig.13.**

**Fig.14.**

Detector

31    32

27

25

15    15

14

26  28  30  29

**Fig.15.**

33    35

34

**Fig.16.**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 8987754 B1
- US 20180045861 A1
- US 2015228844 A1

**Non-patent literature cited in the description**

- **JANONIS VYTAUTAS et al.** Spatial coherence of hybrid surface Plasmon-phonon-polaritons in shallow n-GaN surface-relief gratings. *OPTICS EXPRESS*, 21 April 2021, vol. 29 (9), 13839-13851

- **JANONIS VYTAUTAS et al.** Investigation of n-type gallium nitride grating for applications in coherent thermal sources. *APPLIED PHYSICS LETTERS*, 18 March 2020, vol. 116 (11), 112103, https://doi.org/10.1063/1.5143220
- **JANONIS VYTAUTAS et al.** Spatial coherence of hybrid surface plasmon-phonon-polaritons in shallow n-GaN surface-relief gratings. *OPTICS EXPRESS*, 21 April 2021, vol. 29 (9), 13839